Europäisches Patentamt

European Patent Office

Office européen des brevets

(11) Veröffentlichungsnummer: **0 464 675 B1**

(12) **EUROPÄISCHE PATENTSCHRIFT**

(45) Veröffentlichungstag der Patentschrift: **14.09.94**

(51) Int. Cl.⁵: **G01P 5/00**, G01F 1/66,
G01R 23/02, G01R 23/00

(21) Anmeldenummer: **91110665.6**

(22) Anmeldetag: **27.06.91**

(54) **Verfahren und Anordnung zur Bestimmung der Schwebungsfrequenz von amplituden- oder intensitätsmodulierten pulsförmigen Signalen.**

(30) Priorität: **29.06.90 DE 4020666**

(43) Veröffentlichungstag der Anmeldung:
**08.01.92 Patentblatt 92/02**

(45) Bekanntmachung des Hinweises auf die
Patenterteilung:
**14.09.94 Patentblatt 94/37**

(84) Benannte Vertragsstaaten:
**CH DE FR GB IT LI**

(56) Entgegenhaltungen:
**US-A- 4 786 168**
**US-A- 4 925 297**

**ICIASF '87, INT. CONGRESS ON INSTRUMEN-TATION IN AEROSPACE SIMULATION FACILI-TIES, 22. Juni 1987, Williamsburg, VA, US, Seiten 121-124; LAYNE & BOMAR: "Discrete fourier transform laser velocimeter signal processor"**

**JOURNAL OF PHYSICS E. SCIENTIFIC IN-STRUMENTS, Bd. 22, Nr. 8, August 1989, Is-hing, Bristol, GB, Seiten 631-637; MATOVIC & TROPEA: "Estimation of LDA signal frequen-cy using the autocovariance (ACV) lag ratio method"**

(73) Patentinhaber: **Schroff, Gerhart**
**Starenweg 6**
**D-71394 Kernen (DE)**

Patentinhaber: **Stetter, Michael**
**Am Hohenstein 4**
**D-73630 Remshalden (DE)**

(72) Erfinder: **Schroff, Gerhart**
**Starenweg 6**
**D-71394 Kernen (DE)**
Erfinder: **Stetter, Michael**
**Am Hohenstein 4**
**D-73630 Remshalden (DE)**

(74) Vertreter: **Wolf, Eckhard, Dr.-Ing. et al**
**Patentanwälte Wolf & Lutz**
**Hauptmannsreute 93**
**D-70193 Stuttgart (DE)**

## Beschreibung

Die Erfindung betrifft ein Verfahren und eine Anordnung mit den im Oberbegriff des Anspruchs 1 bzw. 24 genannten Merkmalen zur Bestimmung der Schwebungsfrequenz von amplituden- oder intensitätsmodulierten pulsförmigen Signalen, insbesondere von Streulichtsignalen, die von bewegten Partikeln ausgelöst und durch räumlich-periodische Hell-/ Dunkeleffekte moduliert werden.

Das erfindungsgemäße Verfahren eignet sich besonders für die Signalauswertung in optischen Velocimetern und dabei insbesondere in Laser-Doppler-Anemometern. Es handelt sich dabei um optische Meßsysteme zur lokalen berührungslosen Geschwindigkeitsmessung von Fluiden. Kleine mit der Fluidströmung mitbewegte Partikel streuen beim Durchqueren eines räumlich-periodischen Hell-Dunkel-Streifenfeldes Licht, welches mit einer Linse auf einen Fotodetektor (Fotodiode) fokussiert wird. Bei der fortschreitenden Bewegung des Partikels sieht der Detektor einen mit einer Schwebungsfrequenz f modulierten Lichtpuls, aus dessen Schwebungsfrequenz bei Kenntnis des Streifenabstands $\Delta x$ des Hell-/Dunkelfeldes die Geschwindigkeit des Partikels $V_s$ senkrecht zum Streifenabstand wie folgt bestimmt werden kann:

$$V_s = f \cdot \Delta x \qquad (1)$$

Im Falle der Laser-Doppler-Anemometrie wird der Ausgangstrahl eines Lasers mit einem optischen Strahlteiler in zwei Teilstrahlen aufgeteilt und diese anschließend mit eine Linse in deren Brennpunkt zum Schnitt gebracht.

Das Schnittvolumen der Laserstrahlen stellt das Meßvolumen dar, das von den Streupartikeln durchflogen wird. Das Meßvolumen wird hierbei von einem System von Interferenzstreifen durchzogen, deren Abstand $\Delta x$ durch die Wellenlänge $\lambda$ des Laserlichts und den Schnittwinkel $2\phi$ der Laserstrahlen gegeben ist:

$$\Delta x = \lambda/(2\sin\phi) \qquad (2)$$

Zur Auswertung gelangen bei den genannten Meßverfahren Lichtpulse mit einer im Idealfall die Gestalt einer Gauß-Kurve aufweisenden Einhüllenden, die mit der Schwebungsfrequenz f moduliert ist.

Bei einer bekannten Anordnung der eingangs angegebenen Art (US-PS 4,786,168) werden die Lichtimpulse in einem Fotodetektor empfangen und in elektrische Analogsignale umgesetzt. Die Analogsignale werden in einem schnellen Analog/Digital-Wandler mit einer konstanten Abtastfrequenz digitalisiert und als digitale Meßwertfolge einem Schieberegister zugeführt. Nach Ermittlung des Lichtpulsendes wird der Abtastzyklus unterbrochen und der Inhalt des Schieberegisters über eine digitale Filterbank, die parallele Bandpaßfilter verschiedener Durchlaßfrequenzbereiche aufweist, einer über Impulszähler verfügenden Auswertelogik zur Bestimmung der Schwebungsfrequenz bzw. Streusignalfrequenz des Streupartikels zugeführt. Um eine befriedigende Frequenzauflösung zu erhalten, werden die Abtastfrequenz des Analog/Digital-Wandlers und die Filterkoeffizienten entsprechend einem durch vorab durchgeführte Testmessungen gewonnenen Frequenzwert eingestellt. Neben dem erhöhten Meßaufwand für die Durchführung der Testmessungen wird dabei als nachteilig empfunden, daß die bekannte Anordnung durch die festgelegte Voreinstellung der Abtastfrequenz hinsichtlich der Frequenzdynamik bzw. des erfaßbaren Frequenzumfangs zu wünschen übrig läßt.

Weiter ist es bei Laser-Doppler-Anemometern an sich bekannt (Layne und Bomar, Int. Congress on Instrumentation in Aerospace Simulation Facilities, S. 121-124 (1987); Matovi & Tropea, J. of Physics E, 22, S. 631-637 (1989)), die abgetasteten Signale zur Bestimmung der Doppler-Frequenzen im Frequenzraum auszuwerten. Die Auswertung erfolgt dabei mittels einer schnellen Fourier-Transformation bzw. eines eine hohe Frequenzauflösung gewährenden Korrelationsverfahrens. Zur Digitalisierung der Streusignale wird ein nutzsignalunabhängig getriggerter und mit konstanter Abtastfrequenz arbeitender Transientenrekorder verwendet, wobei sich wiederum als nachteilig erweist, daß bei hoher Abtastfrequenz entweder zu wenig Schwebungsperioden abgetastet werden oder aber ein hoher Speicher- und Rechenzeitbedarf besteht, und daß bei niedrigerer Abtastfrequenz die erreichbare spektrale Bandbreite gering ist.

Ausgehend hiervon liegt der Erfindung die Aufgabe zugrunde, ein Verfahren und eine Anordnung zu entwickeln, mit dem die Schwebungsfrequenz modulierter pulsförmiger Signale in einem sehr weiten Frequenzbereich und mit hoher Meßrate bestimmt werden kann.

Zur Lösung dieser Aufgabe werden in den Patentansprüchen 1 bzw. 24 angegebenen Merkmalskombination vorgeschlagen. Weitere vorteilhafte Ausgestaltungen und Weiterbildungen der Erfindung ergeben sich aus den jeweiligen abhängigen Ansprüchen.

Die Erfindung geht vor allem von der Erkenntnis aus, daß bei der Auswertung von pulsförmigen Signalen mit unterschiedlicher Schwebungsfrequenz mit gleichbleibender Genauigkeit eine von der Schwebungsfrequenz weitgehend unabhängige Schwebungsperiodenzahl mit einem angepaßten Abtastraster zu erfassen ist. Um dies zu erreichen, wird nach dem erfindungsgemäßen Verfahren vorgeschlagen, daß am Signalanfang ein Abtastvorgang ausgelöst und am Signalende abgebrochen wird, daß bei dem Abtastvorgang die zeitabhängige Signalintensität in einem Zeitraster mit zeitlich abnehmender Abtastfrequenz erfaßt wird und daß die so ermittelte Meßwertfolge zur Bestimmung der Schwebungsfrequenz ausgewertet wird.

Vorteilhafterweise wird die Abtastfrequenz in einer Folge von aufeinanderfolgenden Zeitintervallen schrittweise reduziert, während die Länge aufeinanderfolgender Zeitintervalle in Abhängigkeit von, insbesondere umgekehrt proportional zu der Abtastfrequenz vergrößert werden kann. Vorteilhafterweise wird die Abtastfrequenz in aufeinanderfolgenden Zeitintervallen halbiert, während die Länge aufeinanderfolgender Zeitintervalle verdoppelt wird. Die Länge der Zeitintervalle unterschiedlicher Abtastfrequenz ist zweckmäßig so bemessen, daß sie jeweils die gleiche Anzahl Abtastperioden bzw. Rasterpunkte enthalten. Um auch bei den höchsten vorkommenden Schwebungsfrequenzen eine ausreichende Genauigkeit zu gewährleisten, hat es sich darüberhinaus als vorteilhaft erwiesen, wenn das bei Beginn des Abtastvorgangs startende Zeitintervall mit höchster Abtastfrequenz mehr, vorzugsweise doppelt so viele Abtastperioden als die nachfolgenden Zeitintervalle enthält.

Zur Bestimmung der Schwebungsfrequenz wird zweckmäßig ein einem ausgewählten Teilraster des Zeitrasters zugeordneter Teil der Meßwertfolge ausgewertet. Es bietet sich an, für die Auswertung ein äquidistantes Teilraster zu verwenden, dessen Rasterabstand dem Rasterabstand eines Zeitrasters in der Nähe des Signalendes entspricht. Die Abtastfrequenz zu Beginn eines Abtastvorgangs wird vorteilhafterweise mindestens doppelt so hoch gewählt wie die maximal zu bestimmende Schwebungsfrequenz.

Eine weitere vorteilhafte Ausgestaltung der Erfindung sieht vor, daß die Meßwertfolge eines jeden Signals in einem digitalen Speichermedium abgespeichert und zur Bestimmung der Schwebungsfrequenz vorzugsweise unter Anwendung einer schnellen Fourier-Transformation (FFT) ausgewertet wird. Die Meßwertfolge wird dabei zweckmäßig in einem als FIFO-Speicher (First In-First Out) oder RAM (Random Access Memory) zwischengespeichert und von dort aus auf das Speichermedium zum Zwecke der Auswertung übertragen.

Im Interesse einer möglichst hohen Meßrate wird gemäß einer weiteren bevorzugten Ausgestaltung der Erfindung vorgeschlagen, daß Signalanfang und Signalende meßtechnisch bestimmt werden und daß der Abtastvorgang am Signalanfang startet und am Signalende abgebrochen wird. Um dies zu ermöglichen, werden vorteilhafterweise folgende Verfahrensschritte vorgeschlagen:

- Die momentane Signalintensität wird laufend mit einem ersten und einem gegenüber dem ersten höheren zweiten Schwellenwert verglichen,
- beim ersten Überschreiten des zweiten Schwellenwerts wird der Signalanfang festgestellt und der Abtastvorgang gestartet,
- die Zeitspanne zwischen einem Überschreiten des zweiten und einem Unterschreiten des ersten Schwellenwerts wird gemessen,
- im Anschluß an das Unterschreiten des ersten Schwellenwerts wird eine Prüfzeit bestimmt, die länger als die zuvor gemessene Zeitspanne ist,
- das Signalende wird spätestens dann festgestellt und der Abtastvorgang abgebrochen, wenn der zweite Schwellenwert innerhalb der Prüfzeit nicht überschritten wird.

Die Prüfzeit wird dabei zweckmäßig mindestens doppelt so lang, vorzugsweise viermal so lang wie die zuvor gemessene Zeitspanne gewählt. Mit diesem sogenannten "Monoflop-Test" läßt sich die Signaldauer recht zuverlässig nach oben hin eingrenzen. Allerdings kann es im ungünstigsten Fall vorkommen, daß der Abtastvorgang erst nach dem vierfachen der tatsächlichen Signaldauer abgebrochen wird. Dies kann sich unter Umständen nachteilig auf die Meßrate auswirken.

Um dies zu vermeiden, kann das Signal zur Bestimmung des Signalendes parallel zum Monoflop-Test einer weiteren meßtechnischen Analyse unterzogen werden, dem sogenannten "Maximum-Test":

- Die momentane Signalintensität wird mit einem oberhalb des zweiten Schwellenwerts liegenden dritten Schwellenwert verglichen,
- bei Erreichen eines relativen Signalmaximums oberhalb des dritten Schwellenwerts (gegebenenfalls nach vorherigem Unterschreiten des ersten Schwellenwerts) wird die vom Signalanfang an gemessene momentane Signaldauer erfaßt und eine sich an die erfaßte Signaldauer anschließende Auslaufzeit in Lauf gesetzt,
- der Abtastvorgang wird abgebrochen, wenn die zuletzt in Lauf gesetzte Auslaufzeit beendet ist.

Je nach Verlauf der Signal-Einhüllenden kann die Auslaufzeit das 0,6 bis 1,8-fache, vorzugsweise das 0,8 bis 1,2-fache der zuvor erfaßten momentanen Signaldauer betragen.

Um beim Maximum-Test einen zu frühen Abbruch des Abtastvorgangs zu vermeiden, wird zur Bestimmung des Signalendes parallel dazu eine weitere Signalanalyse vorgeschlagen, der sogenannte "Schwellwert-Test":

- Der Abtastvorgang wird erst abgebrochen, wenn die zuletzt in Lauf gesetzte Auslaufzeit beendet ist und zugleich die Signalintensität einen vorgegebenen vierten Schwellenwert unterschritten hat.

Der vierte Schwellenwert sollte einen ausreichenden Abstand vom Rauschpegel des Signals besitzen. Er kann beispielsweise dem ersten Schwellenwert entsprechen.

Bei optischen Velocimetern und Laser-Doppler-Anemometern erzeugen die durch das Meßvolumen fliegenden Partikel unterschiedlicher Geschwindigkeit pulsförmige Streulichtsignale, die eine von der Schwebungsfrequenz weitgehend unabhängige Schwebungsperiodenzahl besitzen. Typische Werte sind etwa 30 bis 50 Schwebungsperioden pro Signal. Unter Berücksichtigung des Abtasttheorems bedeutet dies, daß die Meßwertfolgen verschiedener Signale in einem an die Schwebungsfrequenz angepaßten Zeitraster mit einer von der Schwebungsfrequenz unabhängigen gleichen Stützpunktzahl zur Auswertung gebracht werden sollten, um eine von der Frequenz unabhängige Auswertegenauigkeit zu erhalten. Wenn im Sinne der Erfindung die Abtastfrequenz in aufeinanderfolgenden Zeitintervallen halbiert und die Länge aufeinanderfolgender Zeitintervalle verdoppelt wird, kann bereits während des Abtastvorgangs die Meßwertfolge so verdichtet werden, daß mit geringstmöglichem Speicherbedarf eine optimale Signalauswertung möglich ist.

Um dies zu erreichen, wird gemäß der Erfindung vorgeschlagen, daß die in einem Zwischenspeicher abgespeicherte Meßwertfolge im Zuge des Abtastvorgangs unter Erzeugung einer zu einem äquidistanten Zeitraster gehörenden Meßwertfolge schrittweise verdichtet wird. Das äquidistante Zeitraster entspricht dabei in jedem Augenblick der momentanen Abtastfrequenz. Vorteilhafterweise werden zu diesem Zweck die bei höherer Abtastfrequenz abgespeicherten nichtäquidistanten Zwischenwerte mit zum äquidistanten Zeitraster gehörenden Meßwerten überschrieben. Diese Datenverdichtung kann entweder durch Umspeichervorgänge, beispielsweise mittels zweier hintereinander angeordneter FIFO-Speicher, oder - ohne Umspeicherung - mit Hilfe einer geeigneten Adressierlogik unter Verwendung eines RAM-Speichers durchgeführt werden.

Bei einer Anordnung zur Bestimmung der Schwebungsfrequenz von amplituden- oder intensitätsmodulierten pulsförmigen Signalen, insbesondere von durch bewegte Partikel ausgelösten und durch räumlich wechselnde Hell-Dunkeleffekte modulierten Streulichtsignalen, die einen Signalempfänger, einen mit dem Ausgangssignal des Signalempfängers beaufschlagten Analog/Digital-Umsetzer, an dessen Ausgang eine digitale Meßwertfolge abgreifbar ist, mit der digitalen Meßwertfolge beaufschlagte digitale Speichermittel, eine Signalerkennungslogik, einen mit dem Ausgangssignal der Signalerkennungslogik ansteuerbaren Taktgenerator zur Erzeugung eines den Analog/Digital-Umsetzer und/oder die Speichermittel mit der Abtastfrequenz taktenden Taktsignals, und eine Auswerteanordnung zur Bestimmung der Schwebungsfrequenz aus der digitalen Meßwertfolge aufweist, wird die vorstehend angegebene Erfindungsaufgabe dadurch gelöst, daß der Analog/Digital-Umsetzer mit einem Taktsignal mit zeitlich abnehmender Abtastfrequenz ansteuerbar ist. Die Abtastfrequenz kann dabei in aufeinanderfolgenden Zeitintervallen schrittweise reduziert werden. Vorteilhafterweise wird dies dadurch erreicht, daß der Taktgenerator einen Abtastfrequenzteiler aufweist, in welchem die Abtastfrequenz in aufeinanderfolgenden Zeitintervallen halbierbar ist. Die Zahl der Stützpunkte der Meßwertfolge kann innerhalb der Zeitintervalle durch ein Schaltungsmittel zur Verdoppelung der Länge aufeinanderfolgender Zeitintervalle konstant gehalten werden.

Im folgenden wird die Erfindung anhand der Zeichnung näher erläutert. Es Zeigen

Fig. 1 den prinzipielleen Verlauf eines pulsförmigen, mit einer Schwebung überlagerten Signals;

Fig. 2 ein Schema eines Zeitrasters zur Abtastung eines pulsförmigen Signals gemäß Fig. 1;

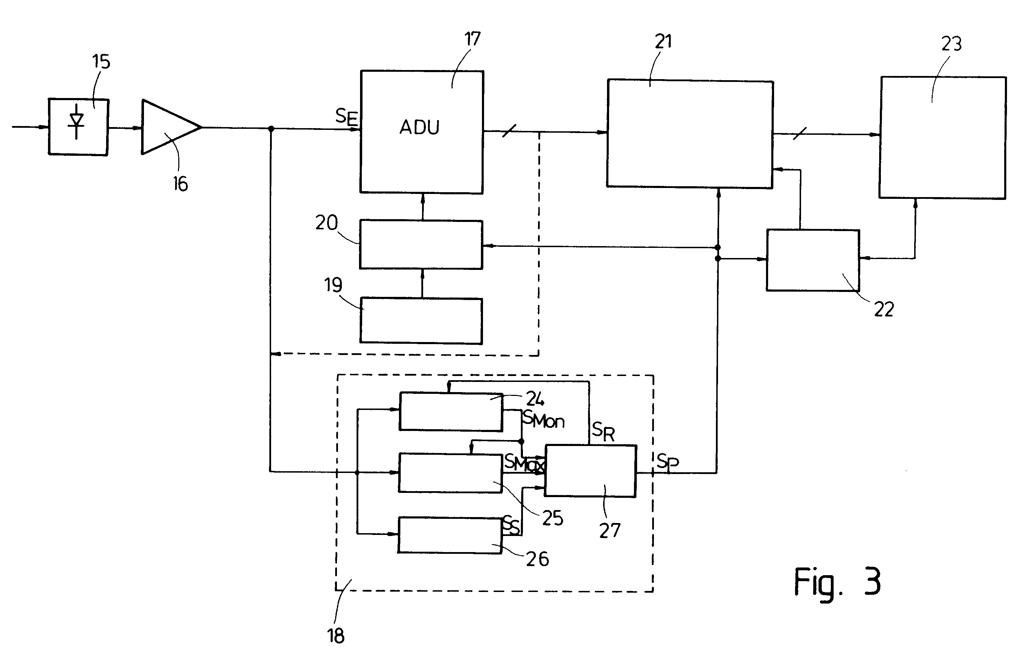

Fig. 3 ein Blockschaltbild einer Signalausdweschaltung;

Fig. 4 ein Schaltschema einer Signalausweteschaltung mit Datenkomprimierung;

Fig. 5 ein Schaltschema für den Monoflop-Test zur Signalerkennung;

Fig. 6 ein Schaltschema für den Maximum-Test zur Bestimmung des Signalendes;

Fig. 7 ein Schaltschema für den Schwellwert-Test zur Signalerkennung;

Fig. 8 ein Schaltschema einer Verknüpfungslogik für die Signalerkennung.

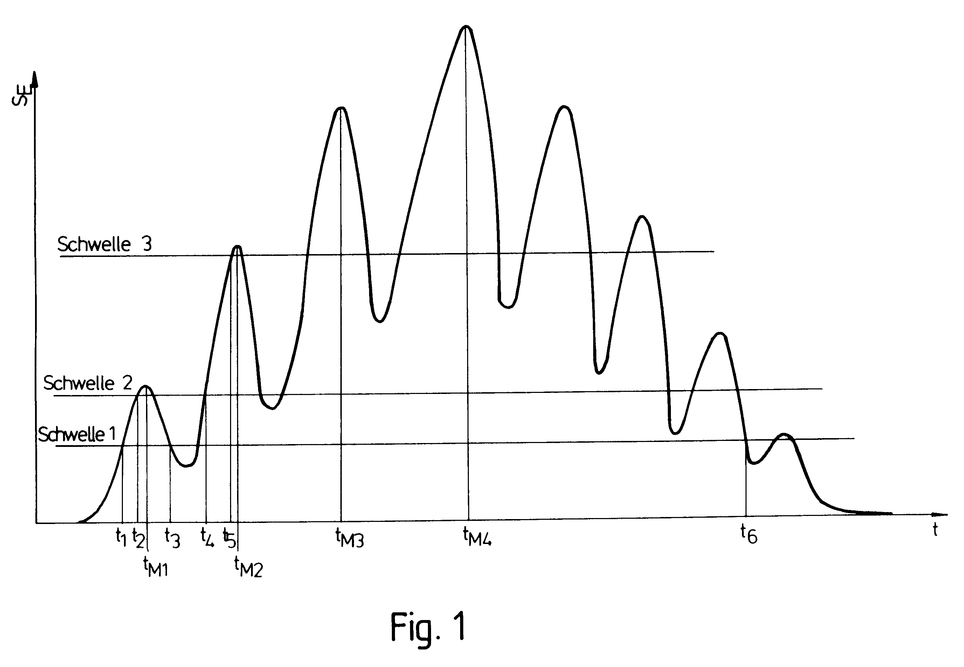

Mit dem nachstehend beschriebenen Verfahren werden pulsförmige Signale der in Fig. 1 in einem Zeit-Amplitudendiagramm dargestellten Form ausgewertet. Das Signal weist eine im wesentlichen symmetrische Gestalt mit einer gaußkurvenartigen Einhüllenden und einer dieser überlagerten periodischen Schwebung mit der Schwebungsfrequenz f auf. Signale dieser Art (Bursts) werden in optischen Velocimetern, insbesondere Laser-Doppler-Anemometern (LDA) durch Partikel ausgelöst, die beim Durchqueren eines räumlich-periodischen Hell-Dunkel-Streifenfeldes Streulicht emittieren. Durch entsprechende Wahl der Größe eines Meßvolumens kann die Zeit, die ein einzelner Partikel braucht, um das Meßvolumen zu durchlaufen, kürzer als die Zeit zwischen dem Eintreffen zweier verschiedener Partikel im Meßvolumen eingestellt werden. Es entsteht also eine Totzeit zwischen dem Auftreffen einzelner Signale. Die zu messende Größe ist dabei die Schwebungsfrequenz jedes einzelnen Signals, da diese Frequenz proportional zur Geschwindigkeit des jeweiligen Partikels ist (s. Gleichung 1). Typisch für LDA-Signale ist, daß die Anzahl der Schwebungsperioden innerhalb eines Signals eine gewisse maximale Zahl (ca. 50) nicht überschreiten kann, da die Anzahl der Hell-Dunkelstreifen im Meßvolumen sich nicht ändert.

Zur Bestimmung der Schwebungsfrequenz eines einzelnen Signals kann beispielsweise die schnelle Fourier-Transformation (Fast Fourier Transform: FFT) verwendet werden. Das Signal muß dazu in einem Zeitraster unter Bestimmung einer Folge von Intensitätsmeßwerten abgetastet und in digitalisierter Form einem Speicher zugeführt werden. Die abgespeicherte Information kann dann mit Hilfe eines Rechners fouriertransformiert werden.

Es ist zwar grundsätzlich möglich, mit einer konstanten Abtastfrequenz zu arbeiten. Dabei ergibt sich jedoch eine erhebliche Einschränkung des erfaßbaren Geschwindigkeitsbereichs. Soll nämlich ein schnelles Teilchen mit beispielsweise 10 MHz Schwebungsfrequenz (dies entspricht bei einem Interferenzstreifenabstand von 5 $\mu$m einer Geschwindigkeit von 50 m/s) erfaßt werden, ist eine Abtastfrequenz von mindestens 20 MHz erforderlich (Abtasttheorem). Um nun bei gleicher Abtastfrequenz auch ein langsameres Teilchen mit einer Schwebungsfrequenz von beispielsweise 10 kHz (entsprechend 5 cm/s) erfassen zu können, wird wegen der längeren Meßzeit ein relativ großer Speicher erforderlich. Hierbei muß also immer ein Kompromiß zwischen dem Dynamikumfang der Geschwindigkeit und der benötigten Speichergröße getroffen werden.

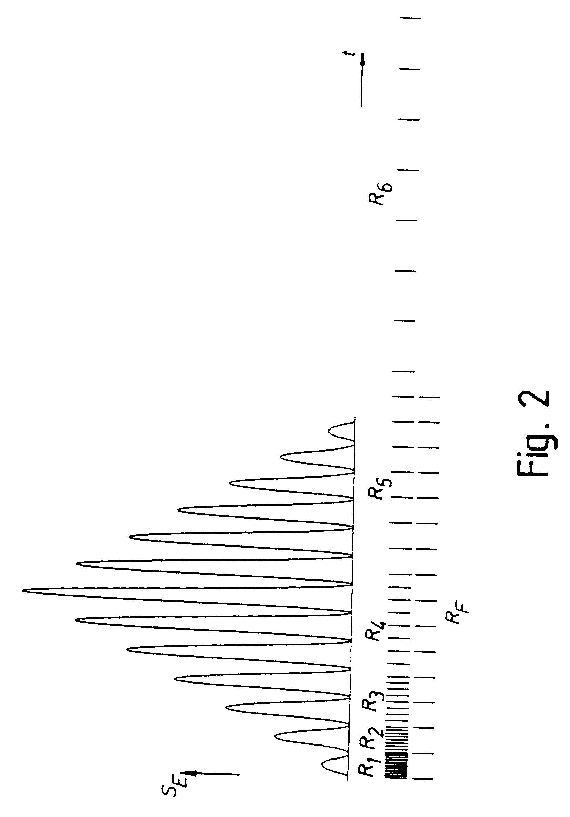

Mit der im folgenden beschriebenen Verfahrensweise läßt sich dieses Problem umgehen. Sobald das Eintreffen eines Partikels im Meßvolumen festgestellt wird (das Signal überschreitet einen Schwellenwert), wird eine Abtastsequenz gestartet (Strichmuster in Fig. 2 unten). Diese Abtastsequenz läuft immer gleich ab, unabhängig von der Partikelgeschwindigkeit und damit von der Schwebungsfrequenz. Die Sequenz beginnt in einem ersten Zeitintervall $R_1$ mit Abtastungen in einem äquividistanten Zeitraster mit einer vorgegebenen maximalen Abtastfrequenz. Nach n Abtastungen (z.B. n = 1024) wird in einem Zeitintervall $R_2$ die Abtastfrequenz verringert (z.B. halbiert) und es werden weitere m Abtastungen (z.B. m = n/2) vorgenommen. Anschließend wird die Abtastfrequenz in Zeitintervallen $R_3$, $R_4$, $R_5$, $R_6$ usw. weiter verringert und jeweils weitere m Abtastungen vorgenommen. Die Sequenz wird fortgeführt, bis die Signalintensität $S_E$ eindeutig auf Null abgesunken ist, d.h. der Partikel das Meßvolumen verlassen hat. Wird die Abtastfrequenz in den aufeinanderfolgenden Zeitintervallen

$R_1$ bis $R_6$ jeweils halbiert, so kann für die FFT immer ein Teilraster $R_F$ mit n äquidistanten Abtastwerten aus der Menge aller abgetasteten Werte herausgegriffen werden. Jeder senkrechte Strich in Fig. 2 bedeutet einen Abtastzeitpunkt. Mit der so verringerten Abtastfrequenz ist es immer, auch bei sehr langsamen Partikeln gewährleistet, daß das Abtasttheorem nicht verletzt wird, daß also keine Information über das Signal verlorengeht. Der Vorteil dieses Prinzips der exponentiell abnehmenden Abtastfrequenz besteht darin, daß der Speicherbedarf für die Meßwertfolge nur logarithmisch und nicht linear mit der Meßzeit anwächst. Weiter ist es damit möglich, z.B. einen Partikel mit einer Geschwindigkeit von 1 mm/s unmittelbar nach einem Partikel mit einer Geschwindigkeit von 50 m/s zu messen. Es kann also ein sehr großer Dynamikbereich ohne Änderung der Systemparameter (z.B. Filtergrenzfrequenzen, Abtastfrequenzen etc.) erfaßt werden. Gleichzeitig bleiben die Vorteile der FFT (hohe Genauigkeit auch bei geringem Signal/Rauschverhältnis) erhalten. Um eine möglichst hohe Meßrate zu erhalten, sollte der Abtastvorgang unverzüglich nach dem Signalende abgebrochen werden. Dies ist notwendig, um Speicherplatz zu sparen und das Meßsystem wieder für das nächste Signal freizumachen. Denn jedes Signal muß anfangs mit der maximalen Abtastfrequenz abgetastet werden.

Das im optischen Velocimeter von einem Partikel ausgesandte Streulichtsignal wird in einem optischen Empfänger 15 in ein elektrisches Analog-Signal umgewandelt und in einem Signalverstärker 16 so verstärkt, daß es in dem Analog-Digitalumsetzer 17 bzw. einer Signalerkennungsschaltung 18 weiterverarbeitet werden kann. Der A/D-Umsetzer 17 wird über einen Oszillator 19 und einen Abtastfrequenzteiler 20 mit einer Abtastfrequenz getaktet, die nach einem vorgegebenen Abtastraster schrittweise reduziert wird. Die digitalen Ausgangssignale werden sequentiell in einen Digitalspeicher 21 eingelesen und können von dort aus über eine Ausleselogik 22 in einen Rechner 23 zur Auswertung ausgelesen werden.

Die Signalerkennungsschaltung 18 analysiert das vom Signalverstärker 16 kommende analoge oder das vom A/D-Wandler 17 kommende digitale Signal $S_E$ in unten näher beschriebenen Schaltungsteilen 24, 25 und 26 nach verschiedenen Kriterien, so daß über eine Verknüpfungslogik 27 nur über die tatsächliche Signaldauer ein Abtast- und Speichervorgang ausgelöst wird.

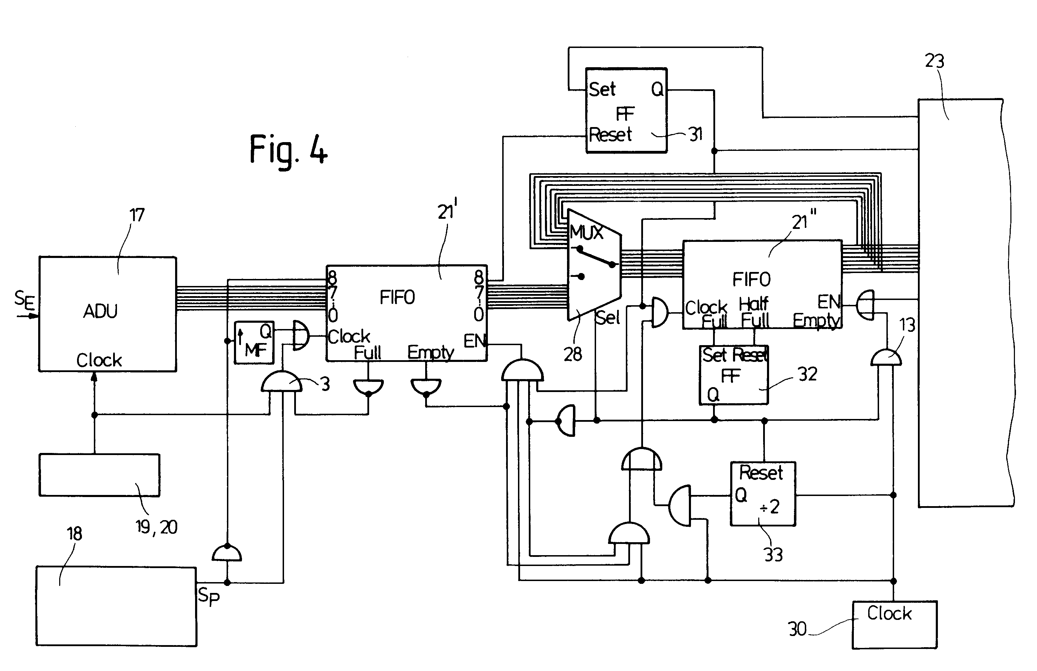

Bei dem beschriebenen Abtastvorgang mit abnehmender Abtastfrequenz werden zu Beginn einer Abtastsequenz unter Umständen (d.h. bei langsamer Schwebungsfrequenz) viele Abtastwerte erfaßt, die "zwischen" dem äquidistanten Zeitraster $R_F$ für die FFT liegen, also letztlich nicht ausgewertet werden. Mit der in Fig. 4 in einem Blockschaltbild gezeigten Logik ist es dagegen möglich, die nichtäquidistanten Zwischenwerte im Zuge des Abtastvorgangs zu eliminieren und dadurch Speicherplatz zu sparen. An zentraler Stelle zwischen dem eingangsseitig mit dem pulsförmigen Signal $S_E$ beaufschlagten Analog-Digital-Umsetzer (ADU) 17 und dem die FFT durchführenden Rechner 23 befinden sich zwei First In-First Out-Speicher (FIFO) 21',21''. FIFO 21' wirkt dabei als Puffer. Das Einlesen vom ADU 17 über die Dateneingänge 0 bis 7 des FIFO 21' erfolgt synchron zum ADU-Takt. Das Auslesen kann dagegen asynchron erfolgen. Mittels eines Multiplexers (MUX; Umschalter) 28 können die Dateneingänge des FIFO 21'' wahlweise mit den Datenausgängen des FIFO 21' oder des FIFO 21'' verbunden werden. Die Ausgangsdaten des FIFO 21'' können auch vom Rechner 23 gelesen werden.

Das FIFO 21' besitzt neun Ein- und Ausgänge. Beim FIFO 21'' werden nur acht Ein- und Ausgänge genutzt. Beide FIFOs 21',21'' besitzen einen Takteingang (Clock) zum Einschreiben der Daten, einen Enable-Eingang (EN) zum Auslesen der Daten, sowie zwei bzw. drei Flags, die anzeigen, ob das FIFO voll (Full), halbvoll (Half Full) oder leer (Empty) ist. Zu Beginn eines Abtastvorgangs gibt die Signalerkennung 18 das UND-Gatter 3 frei, so daß die ADU-Daten ins FIFO 21' übertragen werden. Sobald das Signalerkennungssignal $S_p$ inaktiv wird, wird das Bit 8 des letzten Datenwortes gesetzt und das Einlesen des FIFO 21' gestoppt. Mit der Taktfrequenz des Taktgenerators 30 werden die Daten vom FIFO 21' ins FIFO 21'' übertragen, nachdem der Rechner das FIFO 21'' geleert und das Flip Flop 31 gesetzt hat. Sobald das FIFO 21' leer ist, wird die Datenübertragung zum FIFO 21'' gestoppt. Wenn n Datenworte ins FIFO 21'' eingetragen sind, das Full-Flag also aktiv wird, wird das Flip Flop 32 gesetzt. Dies unterbricht die Datenübertragung vom FIFO 21' zum FIFO 21''. Stattdessen wird nun das Auslesen des FIFO 21'' durch Flip-Flop 32 und das Gatter 13 freigegeben. Gleichzeitig wird der MUX 28 über den Select Eingang (Sel) umgeschaltet. Die Einlesefrequenz, erzeugt durch den Frequenzteiler 33 ist nur halb so groß wie die Auslesefrequenz. Es wird also nur jedes zweite ausgelesene Datenwort wieder ins FIFO 21'' eingeschrieben. Das Signal "Half Full" setzt das Flip-Flop 32 zurück, so daß das Übertragen der sich inzwischen im FIFO 21' angestauten Daten fortgeführt werden kann. Dieser Vorgang geht so weiter, bis das Flip Flop 31 vom Bit 8 des FIFO 21' zurückgesetzt wird. Ein gesetztes Bit 8 markiert die Grenze der Datenströme, die von zwei verschiedenen Signalen (Partikeln) erzeugt werden. Nun kann der Rechner 23 das FIFO 21'' entleeren und die Daten z.B. der FFT zuführen. Nach dem Entleeren des FIFO 21'' muß der Rechner das Flip-Flop 31 wieder setzen, damit das FIFO 21'' mit den Daten des nächsten Signals (Partikels) geladen werden kann.

Die Funktionsweise dieser Schaltung ist wie folgt: Beim Abtasten werden anfangs n Abtastungen (z.B. n = 1024) mit maximaler Frequenz vorgenommen. Anschließend werden jeweils n/2 Abtastungen mit sukzessive halbierter Abtastfrequenz vorgenommen. Es wird davon ausgegangen, daß vor jedem Abtastvorgang die beiden FIFOs 21',21'' leer sind. Das FIFO 21'' hat die Speichertiefe n. Die ersten m Abtastwerte werden durch das FIFO 21' hindurch sequentiell über MUX 28 in das FIFO 21'' eingeschrieben, bis das FIFO 21'' voll ist. Wenn nun weitere Abtastwerte (aus dem nächsten Zeitintervall) folgen werden diese im doppelten Zeitraster abgetastet. Dies bedeutet, daß von den n sich bereits im FIFO 21' befindlichen Abtastwerten nur jede zweite in das neue Abtastraster paßt. Deshalb wird das Auslesen des FIFO 21' zunächst gestoppt und der Ausgang des FIFO 21'' über MUX 28 zum eigenen Eingang zurückgekoppelt. Nun wird das FIFO 21'' ausgelesen. Dabei werden immer zwei Werte ausgelesen, wobei einer der beiden Werte wieder am Eingang des FIFO 21'' eingelesen wird. Dies wird fortgeführt, bis alle n ursprünglich im FIFO 21'' vorhandenen Werte ausgelesen sind. Da jeder zweite Wert am Eingang wieder eingelesen wurde, stehen nun n/2 Abtastwerte im FIFO 21''. Das unterbrochene Auslesen des FIFO 21' (Puffer) kann nun fortgesetzt werden. Dabei werden n/2 Abtastwerte ins FIFO 21'' eingelesen, bis dieses voll ist. Alle n nun vorhandenen Werte entsprechen jetzt äquidistanten Abtastungen des pulsförmigen Signals $S_E$. Sobald das FIFO 21'' wieder voll ist, wird die oben beschriebene Prozedur wiederholt, also jeder zweite Wert eliminiert. Dieser Vorgang läuft so lange ab, bis das Ende des Signals $S_E$ erkannt wird. Es befinden sich also nur solche Abtastwerte im FIFO 21'', die äquividistanten Stützstellen entsprechen und nach Überschreiben der Daten in den Rechner direkt einer FFT zugeführt oder im Hauptspeicher des Rechners abgespeichert werden können.

Vor allem bei der Signalabtastung mit variabler Abtastfrequenz, aber auch bei anderen Analyseverfahren ist es wünschenswert, den Anfang des Signals (Eintreffen des Partikels im Meßvolumen) und das Signalende (Verlassen des Meßvolumens) möglichst genau zu kennen. Prinzipiell steckt die Information über die Signaldauer T in der Einhüllenden des Signals. Diese Einhüllende zu bestimmen, ist jedoch insofern problematisch, als die Signaldauer sehr unterschiedlich sein kann (T kann mit dem Faktor $10^5$ variieren) und die Amplitude des Signals aufgrund der Schwebung variabel ist. Wichtig bei der Signal- bzw. Partikelerkennung ist es jedenfalls, daß das Signalende mit Sicherheit erkannt wird. Wäre dies nicht der Fall, so wäre das Meßsystem lange Zeit blockiert, was einem Totalausfall gleichkommen würde.

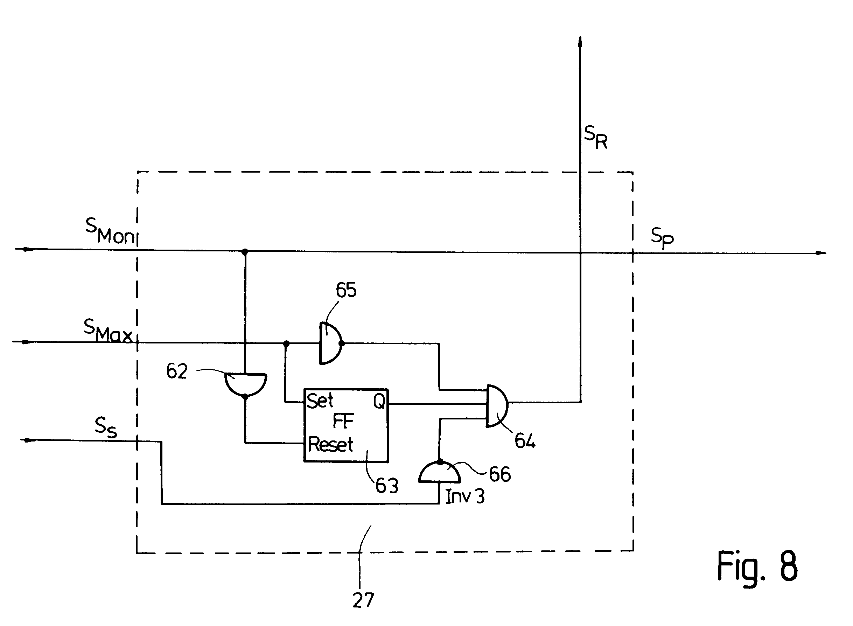

Ein Partikel ist immer dann mit Sicherheit im Meßvolumen vorhanden, wenn eine bestimmte Signalintensität überschritten wird (Schwellwert-Test). Dieses Kriterium kann entsprechend dem Blockschaltbild 26 nach Fig. 7 mit einem Komparator 34 realisiert werden, der eingangsseitig mit dem Eingangssignal $S_E$ und einem Schwellenwert (Schwelle 1) beaufschlagt ist und an dem ein Ausgangssignal $S_S$ abgegriffen werden kann. Das Ausgangssignal $S_S$ ist aktiv, wenn die Schwelle 1 überschritten wird, ansonsten inaktiv. Wie aus Fig. 1 zu erkennen ist, ist das Überschreiten der Schwelle 1 als Kriterium allein nicht ausreichend, da diese Schwelle aufgrund der Schwebung im Zeitverlauf mehrfach unterschritten wird, obwohl das Signalende noch nicht erreicht ist. Für eine zuverlässige Signalerkennung sind daher weitere Kriterien erforderlich.

Beim sogenannten "Monoflop-Test" wird die Zeit vom Überschreiten der Schwelle 2 bis zum Unterschreiten der Schwelle 1 gemessen, d.h. $t_x = t_3 - t_2$ (vgl. Fig. 1). Wird die Schwelle 2 vor dem Zeitpunkt $t_3 + ct_x$ (z.B. c = 4) wieder überschritten, so ist das Signal immer noch vorhanden. Ansonsten wird angenommen, daß das Signalende erreicht ist, d.h. daß der Partikel das Meßvolumen bereits wieder verlassen hat. Wird die Schwelle 2 erneut überschritten ($t_4$), so wird die Prüfzeit $t_x$ bis zum neuerlichen Unterschreiten der Schwelle 1 gemessen ($t_x = t_6 - t_4$). Von da an wird wieder die Zeit $ct_x$ abgewartet, um festzustellen, ob die Schwelle 2 wieder überschritten wird, und so weiter. Es ist leicht ersichtlich, daß der Monoflop-Test in vielen Fällen erst einige Zeit nach dem tatsächlichen Signalende zur Ruhe kommt. Diese Zeit ist jedoch vertretbar, da sie proportional zur Signaldauer ist. Der Monoflop-Test führt jedenfalls immer zu einer Terminierung des erfaßten Signals. Bei richtiger Wahl der Schwellen 1 und 2 kann auch der Signalanfang zuverlässig festgestellt werden.

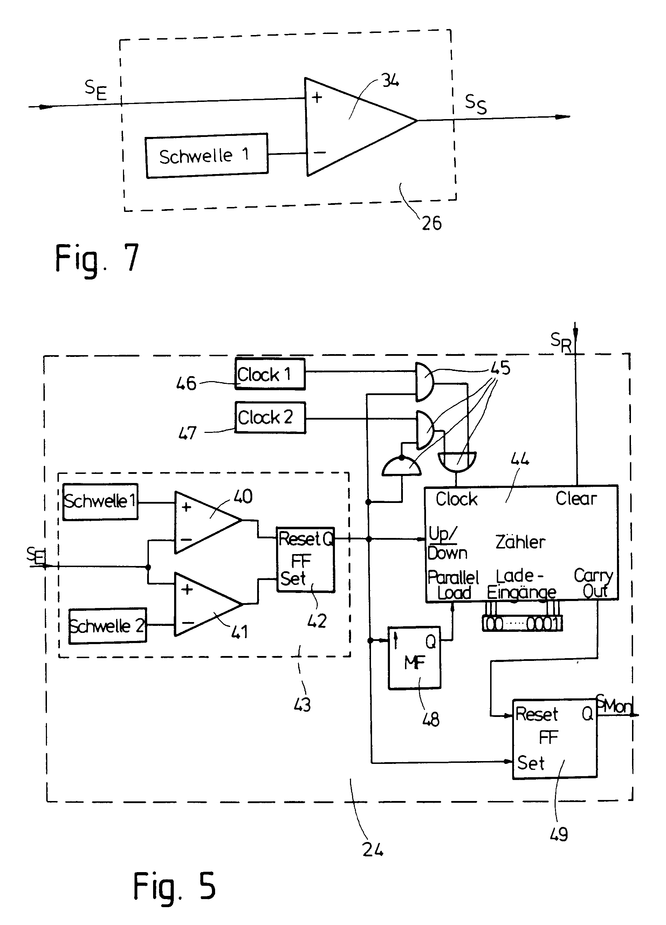

Die in Fig. 5 gezeigte Schaltungsanordnung 24 ist zur Durchführung des Monoflop-Tests geeignet. Die beiden mit dem pulsförmigen Eingangssignal $S_E$ beaufschlagten Komparatoren 40,41 mit den Schwellen 1 und 2 bilden zusammen mit dem Flip Flop 42 einen Schmitt-Trigger 43. Steigt das Eingangssignal $S_E$ von einem niedrigen Wert (Schwelle 1) aus an, so wird das Ausgangssignal des Flip Flops 42 aktiv, sobald die Schwelle 2 überschritten wird. Fällt dann das Eingangssignal $S_E$ wieder, so wird das Flip-Flop 42 inaktiv, wenn das Eingangssignal $S_E$ die Schwelle 1 unterschreitet (Hysterese). Der angekoppelte Zähler 44 zählt aufwärts, wenn das Flip Flop 42 aktiv ist und abwärts, wenn das Flip Flop 42 inaktiv ist (Up/Down-Eingang). Die Gatter 45 bewirken, daß beim Aufwärtszählen die Taktfrequenz 46 und für das Abwärtszählen die Taktfrequenz 47 zum Clock-Eingang des Zählers 44 durchgeschaltet wird. Die Taktfrequenz 46 ist um den Faktor c höher als die Taktfrequenz 47, z.B. c = 4, wobei die Taktfrequenz 46 hinreichend groß gewählt werden muß. Bei jeder ansteigenden Flanke (Flip Flop 41 von inaktiv nach aktiv) erzeugt das Monoflop 48 einen kurzen Ausgangsimpuls in der Größenordnung von zwei bis drei Perioden des Zählertaktes.

Überschreitet das Eingangssignal $S_E$ zum ersten Mal die Schwelle 2, so wird das Flip Flop 42 aktiv. Dadurch wird das Flip Flop 49 gesetzt, das Ausgangssignal $Q = S_{Mon}$ des Flip-Flops 49 also aktiv und gleichzeitig das Monoflop 48 ausgelöst. Während des kurzen Monoflop-Impulses auf den Parallel-Load-Eingang des Zählers 44 wird über die Ladeeingänge die Zahl 1 (kleinste Zahl über Null) in den Zähler 44 geladen. Dann fängt der Zähler 44 an, mit dem Takt 46 aufwärtszuzählen. Wenn nach einiger Zeit das Eingangssignal $S_E$ die Schwelle 1 wieder unterschreitet, wird das Flip Flop 42 inaktiv gesetzt. Beginnend mit dem dann erreichten Zählerstand fängt der Zähler 44 an abwärts zu zählen, und zwar mit dem langsameren Takt 47. Wird das Flip Flop 42 bei einem erneuten Überschreiten der Schwelle 2 wieder aktiv, bevor der Zähler 44 Null erreicht hat, so wird er erneut mit der Zahl 1 geladen und wieder aufwärts zählen. Dieses neue Starten des Zählers 44 kann sich mehrmals wiederholen, bis der Zähler schließlich - einige Zeit nach dem Verschwinden des Eingangssignals $S_E$ - auf Null heruntergezählt hat. Der Zählerstand Null des Zählers wird durch das Carry Out-Signal angezeigt, welches das Flip Flop 49 zurücksetzt, so daß das Ausgangssignal $S_{Mon}$ inaktiv wird.

Wie unten noch erläutert wird, kann das Abwärtszählen des Zählers 44 auch mit einem externen Reset-Signal $S_R$ über den Clear-Eingang des Zählers 44 beendet werden, so daß auch das Ausgangssignal $S_{Mon}$ inaktiv wird.

Mit dem sogenannten "Maximum-Test" kann bei geeigneten Signalformen das Signalende genauer bestimmt werden, als mit dem Monoflop-Test allein. Der Maximum-Test funktioniert jedoch immer nur dann, wenn vom ersten Überschreiten der Schwelle 2 ($t_2$) an gerechnet mindestens eine Schwebungsperiode vergangen ist (Fig. 1). Dieser Test wird daher erst aktiviert, wenn eine weitere Schwelle 3 überschritten wird ($t_5$). Nun wird die momentane Signaldauer vom Signalanfang bis zum ersten relativen Maximum gemessen ($t_M = t_{M2} - t_2$), und von hier aus eine Ablaufzeit $at_M$ (z.B. a = 0,8 bis 1,2) bestimmt. Tritt vor dem Zeitpunkt $t_{M2} + at_M$ ein neues relatives Maximum auf ($t_{M3}$), so wird eine neue momentane Signaldauer ($t_M = t_{M3} - t_2$) erfaßt und eine neue Ablaufzeit $at_M$ festgelegt. Im Falle des in Fig. 1 dargestellten Signals tritt das letzte Maximum bei $t_{M4}$ auf. Das bedeutet, daß nach dem Maximum-Test das Signalende bei $t_{M4} + at_M$ (mit $t_M = t_{M4}-t_2$) festgelegt wird. Bei symmetrischen Signalen mit $a=1$ kann das Signalende sehr genau bestimmt werden.

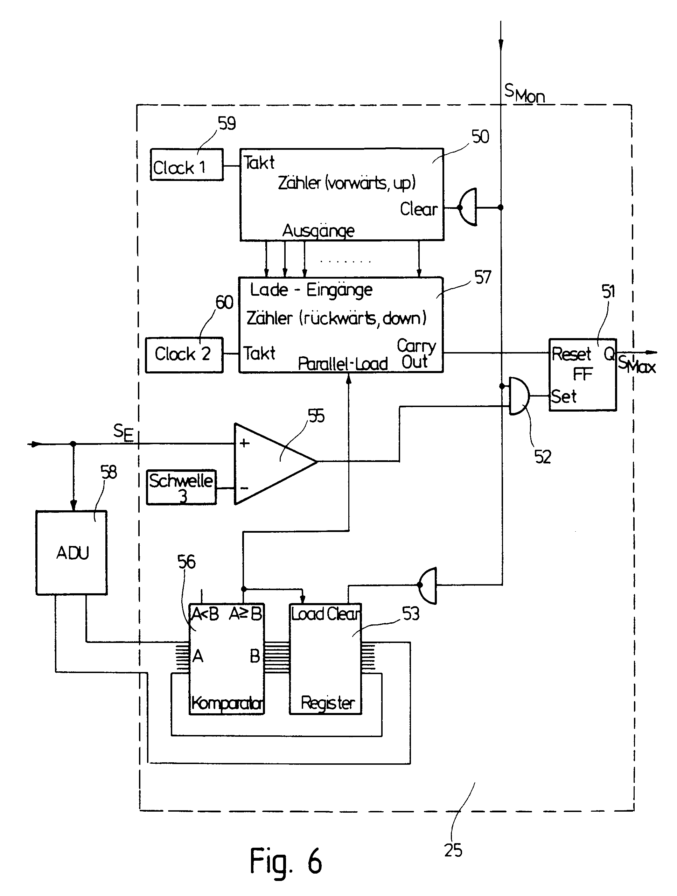

In Fig. 6 ist ein Blockschaltbild 25 für die Durchführung des Maximum-Tests gezeigt. Die Freigabe des Maximumtests erfolgt über das Ausgangssignal $S_{Mon}$ der Monoflop Schaltung 24 nach Fig. 5. Solange das Monoflop-Signal $S_{Mon}$ inaktiv ist, bleibt der als Vorwärtszähler ausgebildete Timer 50 und das Register 53 auf Null stehen (Clear). Der Set-Eingang des Flip-Flops 51 bleibt durch das UND-Gatter 52 gesperrt. Das Flip-Flop 51 bleibt also zurückgesetzt und das Ausgangssignal $S_{Max}$ der Schaltung 25 bleibt inaktiv. Sobald das Ausgangssignal $S_{Mon}$ der Monoflop-Schaltung 24 (Fig. 5) aktiv wird, wird das Register 53 freigegeben und der Timer 50 fängt an zu zählen. Erst wenn die Schwelle 3 überschritten wird, wird das Flip-Flop 51 über den Komparator 55 gesetzt und das Ausgangssignal $S_{Max}$ aktiv. Zu diesem Zeitpunkt läuft der Timer 50 bereits einige Zeit, der Zählerstand ist also größer Null. Nun können die Spitzenwerterkennung, bestehend aus Komparator 56 und Register 53 und der Timer 57 aktiv werden. Der Komparator 56 vergleicht das vom A/D-Wandler 58 kommende Eingangssignal (Eingang A) mit dem Inhalt des Registers 53 (Eingang B), wobei der Registerinhalt anfangs stets auf Null steht. Wird das Eingangssignal größer oder gleich dem Registerinhalt (Ausgang A = B aktiv), so übernimmt der Timer 57 den Zählerstand des Timers 50. Sobald aber das Eingangssignal kleiner wird als der größte zuvor aufgetretene und nun im Register zwischengespeicherte Wert des Eingangssignals (bisheriger Maximalwert), wird der Ausgang A = B inaktiv und der Timer 57 beginnt rückwärts zu zählen. Tritt ein neuer Eingangswert auf, der höher als der im Register gespeicherte Wert ist, bevor der Timer 57 auf Null zurückgezählt hat, wird der Timer 57 mit dem aktuellen Zählerstand des Timers 50 geladen. Dies geht so weiter, bis das absolute Maximum des Eingangssignals $S_E$ erreicht ist. Sodann zählt der Timer 57 zurück, bis er Null erreicht hat (Carry Out aktiv) und das Flip Flop 51 zurücksetzt. Das Ausgangssignal $S_{Max}$ fällt nun ab. Unmittelbar danach oder etwas später wird von der nachstehend erläuterten Verknüpfungslogik 27 (Fig. 8) die Monoflop-Schaltung 24 (Fig. 5) zurückgesetzt (Monoflop-Signal $S_{Mon}$ inaktiv) und der Abtastvorgang abgebrochen (Signalende). Die Taktfrequenz 59 des Timers 50 muß hinreichend hoch sein, damit die Quantisierungsstufen der Zeit (bedingt durch den digitalen Zählvorgang) genügend klein sind im Vergleich zur Dauer des schnellsten vorkommenden Signals. Die Taktfrequenz 60 ist um den Faktor 1/a schneller oder langsamer als die Taktfrequenz 59. Bei symmetrisch zu erwartenden Signalen wird $a=1$ gewählt.

Bei dem Analog/Digitalumsetzer 58 handelt es sich um den zentralen A/D-Wandler der Gesamtschaltung. Der Schwellenwertschalter 55 ist als analoger Komparator dargestellt, während der Spitzenwertspeicher 53,56 digital realisiert ist. Grundsätzlich könnten beide Schaltungsteile analog oder digital verwirklicht werden.

Jeder der drei beschriebenen Tests hat Vor- und Nachteile. Der Signalanfang und das späteste Signalende werden zuverlässig über den Monoflop-Test (Schaltung 24) bestimmt. Eine genauere Bestimmung des Signalendes kann jedoch bei geeigneter Signalform über den Maximum-Test (Schaltung 25) erfolgen. Dementsprechend können die drei Tests bei der Signalerkennung wie folgt miteinander verknüpft werden: Der Signalanfang wird immer vom Monoflop-Test erkannt. Wird im Signalverlauf die Schwelle 3 überschritten, so wird zur Bestimmung des Signalendes auf den Maximum-Test übergegangen. Ist nach dem Terminieren durch den Maximum-Test das Signal noch über der Schwelle 1, so wird der Abtastvorgang durch den Schwellwert-Test (Schaltung 26) bis zum Unterschreiten der Schwelle 1 fortgesetzt. Durch eine solche Verknüpfung werden Fehlmessungen mit großer Wahrscheinlichkeit vermieden.

Eine Schaltung 27 zur Durchführung einer solchen Verknüpfung kann etwa wie folgt aufgebaut werden: Das Monoflop-Signal $S_{Mon}$ wird direkt als Ausgangssignal $S_p$ der Verknüpfungslogik 27 verwendet. Vor dem Signalanfang, also bevor ein Partikel in das Meßvolumen eintritt, sind das Monoflopsignal $S_{Mon}$, das Maximumsignal $S_{Max}$ und das Schwellenwertsignal $S_S$ inaktiv. Durch den Inverter 62 ist das Flip Flop 63 bei inaktivem Monoflop-Signal $S_{Mon}$ ständig zurückgesetzt und dessen Ausgangssignal Q inaktiv. Folglich ist das Ausgangssignal des UND-Gatters 64 inaktiv, so daß kein Reset-Signal $S_R$ an die Monoflop-Schaltung (Fig. 5) abgegeben wird. Dieser Zustand bleibt erhalten, bis das Monoflop-Signal $S_{Mon}$ und damit auch das Ausgangssignal $S_p$ der Verknüpfungslogik 61 aktiv wird. Das Flip Flop 63 behält seinen Zustand bei, bis auch das Maximum-Signal $S_{Max}$ aktiv wird, was nicht bei jedem pulsförmigen Signal $S_E$ der Fall sein muß. Damit wird das Flip Flop 63 gesetzt, der Ausgang Q also aktiv. Der Ausgang des Inverters 65 ist nun jedoch inaktiv, so daß die UND-Bedingung für das Gatter 64 noch nicht erfüllt ist, das Reset-Signal $S_R$ also inaktiv bleibt. Erst wenn das Maximum-Signal $S_{Max}$ wieder inaktiv wird, sind Inverter 65 und Flip Flop 63 aktiv. Falls das Schwellwert-Signal $S_S$ aktiv ist, die Schwelle 1 also noch nicht unterschritten ist, bleibt das Reset-Signal $S_R$ noch blockiert. Erst wenn der Inverter 66 aktiv wird, wird das Reset-Signal $S_R$ aktiviert. Dies veranlaßt die Monoflop-Schaltung 24 zur Deaktivierung des Monoflop-Signals $S_{Mon}$ und des Ausgangssignals $S_p$ und damit zum Abbruch des Abtastvorgangs (Signalende).

**Patentansprüche**

1. Verfahren zur Bestimmung der Schwebungsfrequenz von amplituden- oder intensitätsmodulierten pulsförmigen Signalen, insbesondere von durch bewegte Partikel ausgelösten und durch räumlich wechselnde Hell-Dunkeleffekte modulierten Streulichtsignalen, bei welchem am Signalanfang ein Abtastvorgang ausgelöst und am Signalende abgebrochen wird, bei welchem bei dem Abtastvorgang die zeitabhängige Signalintensität in einem vorgegebenen Zeitraster gemessen wird und bei welchem die so ermittelte Meßwertfolge zur Bestimmung der Schwebungsfrequenz ausgewertet wird, **dadurch gekennzeichnet,** daß das Zeitraster mit zeitlich abnehmender Abtastfrequenz vorgegeben wird.

2. Verfahren nach Anspruch 1, **dadurch gekennzeichnet,** daß die Abtastfrequenz in aufeinanderfolgenden Zeitintervallen ($R_1,...,R_6$) schrittweise reduziert wird.

3. Verfahren nach Anspruch 1 oder 2, **dadurch gekennzeichnet,** daß ein einem ausgewählten Teilraster des Zeitrasters zugeordneter Teil der Meßwertfolge zur Bestimmung der Schwebungsfrequenz ausgewertet wird.

4. Verfahren nach einem der Ansprüche 1 bis 3, **dadurch gekennzeichnet,** daß die Abtastfrequenz Zu Beginn eines Abtastvorgangs mindestens doppelt so hoch wie die maximal bestimmbare Schwebungsfrequenz gewählt wird.

5. Verfahren nach einem der Ansprüche 2 bis 4, **dadurch gekennzeichnet,** daß die Länge aufeinanderfolgender Zeitintervalle ($R_1, ..., R_6$) in Abhängigkeit von, insbesondere umgekehrt proportional zu der Abtastfrequenz vergrößert wird.

6. Verfahren nach einem der Ansprüche 2 bis 5, **dadurch gekennzeichnet,** daß die Abtastfrequenz in aufeinanderfolgenden Zeitintervallen ($R_1, ..., R_6$) halbiert wird.

7. Verfahren nach einem der Ansprüche 2 bis 6, **dadurch gekennzeichnet,** daß die Länge aufeinanderfolgender Zeitintervalle ($R_1, ..., R_6$) verdoppelt wird.

8. Verfahren nach einem der Ansprüche 2 bis 7, **dadurch gekennzeichnet,** daß die Zeitintervalle ($R_2, ..., R_6$) mit unterschiedlicher Abtastfrequenz die gleiche Anzahl Rasterpunkte bzw. Abtastperioden enthalten.

9. Verfahren nach einem der Ansprüche 1 bis 8, **dadurch gekennzeichnet,** daß das zu Beginn des Abtastvorgangs startende Zeitintervall ($R_1$) mit höchster Abtastfrequenz mehr Abtastperioden als das nachfolgende Zeitintervall ($R_2$) enthält.

10. Verfahren nach Anspruch 9, **dadurch gekennzeichnet,** daß das zu Beginn des Abtastvorgangs startende Zeitintervall ($R_1$) mit höchster Abtastfrequenz doppelt so viele Abtastperioden wie das nachfolgende Zeitintervall ($R_2$) enthält.

11. Verfahren nach einem der Ansprüche 1 bis 10, **dadurch gekennzeichnet,** daß die Meßwertfolge eines jeden Signals in einem digitalen Speichermedium (21;21',21'') abgespeichert und zur Bestimmung der Schwebungsfrequenz vorzugsweise unter Anwendung einer schnellen Fourier-Transformation (FFT) ausgewertet wird.

12. Verfahren nach einem der Ansprüche 1 bis 11, **dadurch gekennzeichnet,** daß Signalanfang und Signalende meßtechnisch bestimmt werden.

13. Verfahren nach einem der Ansprüche 1 bis 12, **dadurch gekennzeichnet,** daß die Meßwertfolge im Zuge des Abtastvorgangs in mindestens einem als FIFO-(21',21'') oder RAM-Speicher (21) ausgebildeten Zwischenspeicher abgespeichert wird.

14. Verfahren nach einem der Ansprüche 1 bis 13, **dadurch gekennzeichnet,** daß für die Auswertung eine einem äquidistanten Teilraster entsprechende Meßwertfolge verwendet wird, wobei der Rasterabstand dem Rasterabstand eines Zeitintervalls ($R_5$) in der Nähe des Signalendes entspricht.

15. Verfahren nach einem der Ansprüche 1 bis 14, **dadurch gekennzeichnet,** daß die momentane Signalintensität ($S_E$) laufend mit einem ersten und einem gegenüber dem ersten höheren zweiten Schwellenwert verglichen wird, daß beim ersten Überschreiten des zweiten Schwellenwerts der Signalanfang festgestellt und der Abtastvorgang gestartet wird, daß jeweils die Zeitspanne zwischen einem Überschreiten des zweiten und einem Unterschrei-

17       **EP 0 464 675 B1**       18

ten des ersten Schwellenwerts gemessen wird, daß im Anschluß an das Unterschreiten des ersten Schwellenwerts eine Prüfzeit bestimmt wird, die länger als die zuvor gemessene Zeitspanne ist, und daß das Signalende spätestens dann festgestellt und der Abtastvorgang abgebrochen wird, wenn der zweite Schwellenwert innerhalb der Prüfzeit nicht überschritten wird.

16. Verfahren nach Anspruch 15, **dadurch gekennzeichnet,** daß die Prüfzeit mindestens doppelt so lang, vorzugsweise viermal so lang wie die zuvor gemessene Zeitspanne gewählt wird.

17. Verfahren nach einem der Ansprüche 1 bis 16, **dadurch gekennzeichnet,** daß die momentane Signalintensität ($S_E$) mit einem oberhalb eines zweiten Schwellenwerts liegenden dritten Schwellenwert verglichen wird, daß bei Erreichen eines relativen Signalmaximums oberhalb des dritten Schwellenwerts, gegebenenfalls nach vorherigem Unterschreiten eines unterhalb des zweiten Schwellenwerts liegenden ersten Schwellenwerts, die vom Signalanfang an gemessene momentane Signaldauer erfaßt und eine sich an die erfaßte Signaldauer anschließende Auslaufzeit in Lauf gesetzt wird, und daß der Abtastvorgang abgebrochen wird, wenn die zuletzt in Lauf gesetzte Auslaufzeit beendet ist.

18. Verfahren nach Anspruch 17, **dadurch gekennzeichnet,** daß die Auslaufzeit das 0,6 bis 1,8-fache, vorzugsweise das 0,8 bis 1,2-fache der zuvor erfaßten momentanen Signaldauer beträgt.

19. Verfahren nach Anspruch 17 oder 18, **dadurch gekennzeichnet,** daß der Abtastvorgang abgebrochen wird, wenn die zuletzt in Lauf gesetzte Auslaufzeit beendet ist und zugleich die Signalintensität ($S_E$) einen vorgegebenen vierten Schwellenwert unterschritten hat.

20. Verfahren nach Anspruch 19, **dadurch gekennzeichnet,** daß der vierte Schwellenwert dem ersten Schwellenwert entspricht.

21. Verfahren nach einem der Ansprüche 1 bis 20, **dadurch gekennzeichnet,** daß die in einem Zwischenspeicher (21;21',21'') abgespeicherte Meßwertfolge im Zuge des Abtastvorgangs unter Erzeugung einer zu einem äquidistanten Zeitraster gehörenden Meßwertfolge schrittweise verdichtet wird.

22. Verfahren nach Anspruch 21, **dadurch gekennzeichnet,** daß das äquidistante Zeitraster der augenblicklichen Abtastfrequenz entspricht.

23. Verfahren nach Anspruch 21 oder 22, **dadurch gekennzeichnet,** daß die bei höherer Abtastfrequenz abgespeicherten Zwischenwerte zur Verdichtung der Meßwertfolge mit Werten der zum äquidistanten Zeitraster gehörenden Meßwertfolge überschrieben werden.

24. Anordnung zur Bestimmung der Schwebungsfrequenz von amplituden- oder intensitätsmodulierten pulsförmigen Signalen, insbesondere von durch bewegte Partikel ausgelösten und durch räumlich wechselnde Hell-Dunkeleffekte modulierten Streulichtsignalen, mit einem Signalempfänger (15,16), einem mit dem Ausgangssignal ($S_E$) des Signalempfängers beaufschlagten Analog/Digital-Umsetzer (17), an dessen Ausgang eine digitale Meßwertfolge abgreifbar ist, mit der digitalen Meßwertfolge beaufschlagte digitale Speichermittel (21;21',21''), einer Signalerkennungslogik (18), einem mit dem Ausgangssignal ($S_p$) der Signalerkennungslogik (18) ansteuerbaren Taktgenerator (19,20) zur Erzeugung eines den Analog/Digital-Umsetzer (17) und/oder die Speichermittel (21;21',21'') mit der Abtastfrequenz taktenden Taktsignals, und mit einer Auswerteanordnung (23) zur Bestimmung der Schwebungsfrequenz aus der digitalen Meßwertfolge, **dadurch gekennzeichnet,** daß der Analog/Digital-Umsetzer (17) mit einem Taktsignal mit zeitlich abnehmender Abtastfrequenz ansteuerbar ist.

25. Anordnung nach Anspruch 24, **dadurch gekennzeichnet,** daß die Abtastfrequenz in aufeinanderfolgenden Zeitintervallen ($R_1,...,R_6$) schrittweise reduzierbar ist.

26. Anordnung nach Anspruch 25, **dadurch gekennzeichnet,** daß der Taktgenerator (19,20) einen Abtastfrequenzteiler (20) aufweist, in welchem die Abtastfrequenz in aufeinanderfolgenden Zeitintervallen halbierbar ist.

27. Anordnung nach Anspruch 25 oder 26, **gekennzeichnet durch** Schaltungsmittel zur Verdoppelung der Länge aufeinanderfolgender Zeitintervalle.

28. Anordnung nach einem der Ansprüche 24 bis 27, **dadurch gekennzeichnet,** daß die in den digitalen Speichermitteln abgespeicherte Meßwertfolge zur Bestimmung der Schwebungsfrequenz unter Anwendung einer schnellen Fourier-Transformation ausgewertet wird.

10

29. Anordnung nach einem der Ansprüche 24 bis 28, **dadurch gekennzeichnet,** daß die digitalen Speichermittel (21;21',21'') als FIFO- oder RAM-Speicher ausgebildet sind.

30. Anordnung nach einem der Ansprüche 24 bis 29, **gekennzeichnet durch** eine Schaltung oder ein Programm zur Auswahl und Auswertung einer einem äquidistanten zeitlichen Teilraster ($R_F$) entsprechenden Meßwertfolge, wobei der Rasterabstand der Abtastfrequenz in der Nähe des Signalendes entspricht.

31. Anordnung nach einem der Ansprüche 24 bis 30, **gekennzeichnet durch** eine Schaltungsanordnung zur Komprimierung der in den Speichermitteln (21,21'') abgespeicherten Meßwertfolge nach Maßgabe des der augenblicklichen Abtastfrequenz entsprechenden zeitlichen Teilrasters (Fig. 4).

**Claims**

1. Method of determining the beat frequency of amplitude- or intensity-modulated pulse-type signals, in particular scattered-light signals initiated by moving particles and modulated by spatially alternating light/dark effects, in which method a sampling operation is initiated at the beginning of the signal and is discontinued at the end of the signal, in which method the time-dependent signal intensity is measured during the sampling operation in a specified time raster, and in which method the sequence of measured values determined in this way is evaluated to determine the beat frequency, characterized in that the time raster is specified with a sampling frequency which decreases with respect to time.

2. Method according to Claim 1, characterized in that the sampling frequency is reduced stepwise in consecutive time intervals ($R_1$, ..., $R_6$).

3. Method according to Claim 1 or 2, characterized in that a section, assigned to a selected sub-raster of the time raster, of the sequence of measured values is evaluated to determine the beat frequency.

4. Method according to one of Claims 1 to 3, characterized in that the chosen sampling frequency at the beginning of a sampling operation is at least twice as high as the maximum beat frequency which can be determined.

5. Method according to one of Claims 2 to 4, characterized in that the length of consecutive time intervals ($R_1$, ..., $R_6$) is increased as a function of, in particular in inverse proportion to the sampling frequency.

6. Method according to one of Claims 2 to 5, characterized in that the sampling frequency is halved in consecutive time intervals ($R_1$, ..., $R_6$).

7. Method according to one of Claims 2 to 6, characterized in that the length of consecutive time intervals ($R_1$, ..., $R_6$) is doubled.

8. Method according to one of Claims 2 to 7, characterized in that the time intervals ($R_2$, ..., $R_6$) having different sampling frequencies contain the same number of raster points or sampling periods.

9. Method according to one of Claims 1 to 8, characterized in that the time interval ($R_1$) starting at the beginning of the sampling operation and having the highest sampling frequency contains more sampling periods than the subsequent time interval ($R_2$).

10. Method according to Claim 9, characterized in that the time interval ($R_1$) starting at the beginning of the sampling operation and having the highest sampling frequency contains twice as many sampling periods as the subsequent time interval ($R_2$).

11. Method according to one of Claims 1 to 10, characterized in that the sequence of measured values of each signal is stored in a digital memory medium (21; 21', 21'') and is evaluated to determine the beat frequency, preferably using a fast Fourier transform (FFT).

12. Method according to one of Claims 1 to 11, characterized in that the beginning of the signal and the end of the signal are determined metrologically.

13. Method according to one of Claims 1 to 12, characterized in that the sequence of measured values is stored in the course of the sampling operation in at least one interim memory designed as FIFO (21', 21'') memory or RAM memory (21).

14. Method according to one of Claims 1 to 13, characterized in that a sequence of measured values corresponding to an equidistant sub-raster is used for the evaluation, and the raster spacing is equal to the raster spacing of a time interval ($R_5$) in the vicinity of the end of the signal.

15. Method according to one of Claims 1 to 14, characterized in that the instantaneous signal intensity ($S_E$) is continuously compared with a first threshold value and a second threshold value which is higher than the first, in that, when the second threshold value is exceeded for the first time, the beginning of the signal is detected and the sampling operation is started, in that the time interval between the second threshold value being exceeded and the first threshold value being dropped below is measured in each case, in that, subsequent to the first threshold value being dropped below, a test time is determined which is longer than the previously measured time interval, and in that the end of the signal is detected and the sampling operation discontinued at the latest if the second threshold value is not exceeded within the test time.

16. Method according to Claim 15, characterized in that the test time chosen is at least twice as long, preferably four times as long, as the previously measured time interval.

17. Method according to one of Claims 1 to 16, characterized in that the instantaneous signal intensity ($S_E$) is compared with a third threshold value situated above the second threshold value, in that, on reaching a relative signal maximum above the third threshold value, possibly after previously dropping below a first threshold value situated below the second threshold value, the instantaneous signal duration measured from the beginning of the signal is determined and a run-out time subsequent to the signal duration determined is set running, and in that the sampling operation is discontinued if the run-out time last set running has expired.

18. Method according to Claim 17, characterized in that the run-out time is 0.6 to 1.8 times, preferably 0.8 to 1.2 times, the previously determined instantaneous signal duration.

19. Method according to Claim 17 or 18, characterized in that the sampling operation is discontinued if the run-out time last set running has expired and, at the same time, the signal intensity ($S_E$) has dropped below a specified fourth threshold value.

20. Method according to Claim 19, characterized in that the fourth threshold value corresponds to the first threshold value.

21. Method according to one of Claims 1 to 20, characterized in that the sequence of measured values stored in an interim memory (21; 21', 21'') is compressed stepwise in the course of the sampling operation to generate a sequence of measured values associated with an equidistant time raster.

22. Method according to Claim 21, characterized in that the equidistant time raster corresponds to the instantaneous sampling frequency.

23. Method according to Claim 21 or 22, characterized in that the interim values stored at higher sampling frequency are overwritten for the purpose of compressing the sequence of measured values with values of the sequence of measured values associated with the equidistant time raster.

24. Arrangement for determining the beat frequency of amplitude- or intensity-modulated pulse-type signals, in particular scattered-light signals which are initiated by moving particles and are modulated by spatially alternating light/dark effects, which arrangement has a signal receiver (15, 16), an analog/digital converter (17) to which the output signal ($S_E$) of the signal receiver is applied and at whose output a sequence of digital measured values can be tapped off, digital memory means (21; 21', 21'') to which the sequence of digital measured values is applied, a signal detection logic circuit (18), a clock generator (19, 20) which can be triggered by the output signal ($S_p$) of the signal detection logic circuit (18) and is intended to generate a clock signal which clocks the analog/digital converter (17) and/or the memory means (21; 21', 21'') at the sampling frequency, and an evaluation arrangement (23) for the determination of the beat frequency from the sequence of digital measured values, characterized in that the analog/digital converter (17) can be triggered by a clock signal having sampling frequency which decreases with time.

25. Arrangement according to Claim 24, characterized in that the sampling frequency is reduced stepwise in consecutive time intervals ($R_1$, ..., $R_6$).

26. Arrangement according to Claim 25, characterized in that the clock generator (19, 20) has a sampling frequency divider (20) in which the sampling frequency can be halved in consecutive time intervals.

27. Arrangement according to Claim 25 or 26, characterized by circuit means for doubling the length of consecutive time intervals.

28. Arrangement according to one of Claims 24 to 27, characterized in that the sequence of measured values stored in the digital memory means is evaluated to determine the beat frequency using a fast Fourier transform.

29. Arrangement according to one of Claims 24 to 28, characterized in that the digital memory means (21; 21', 21") are designed as FIFO memory or RAM memory.

30. Arrangement according to one of Claims 24 to 29, characterized by a circuit or a program for selecting and evaluating a sequence of measured values corresponding to an equidistant time sub-raster ($R_F$), the raster spacing corresponding to the sampling frequency in the vicinity of the end of the signal.

31. Arrangement according to one of Claims 24 to 30, characterized by a circuit arrangement for compressing the sequence of measured values stored in the memory means (21, 21") in accordance with the time sub-raster corresponding to the instantaneous sampling frequency (Figure 4).

## Revendications

1. Procédé pour déterminer la fréquence de battement de signaux impulsionnels modulés en amplitude ou en intensité, en particulier de signaux de lumière diffusée déclenchés par des particules en mouvement et modulés par des effets de clair-obscur, d'après lequel un processus d'exploration est déclenché au début du signal et interrompu à la fin du signal, l'intensité du signal est mesurée en fonction du temps dans une trame de temps prédéterminée, et la séquence de valeurs mesurées ainsi déterminée est utilisée pour la détermination de la fréquence de battement, **caractérisé en ce** que la trame de temps est prédéterminée avec une fréquence d'échantillonnage diminuant dans le temps.

2. Procédé selon la revendication 1, caractérisé en ce que la fréquence d'échantillonnage est réduite progressivement dans des intervalles de temps consécutifs ($R_1$, ..., $R_6$).

3. Procédé selon l'une des revendications 1 ou 2, caractérisé en ce qu'une partie de la séquence de valeurs mesurées associée à une trame partielle de la trame de temps est utilisée pour la détermination de la fréquence de battement.

4. Procédé selon l'une des revendications 1 à 3, caractérisé en ce que la fréquence d'échantillonnage au début d'un processus d'exploration est choisie au moins deux fois plus grande que la fréquence de battement maximale pouvant être déterminée.

5. Procédé selon l'une des revendications 2 à 4, caractérisé en ce que la durée des intervalles de temps consécutifs ($R_1$, ..., $R_6$) est augmentée en fonction de la fréquence d'échantillonnage, et notamment de manière inversement proportionnelle à celle-ci.

6. Procédé selon l'une des revendications 2 à 5, caractérisé en ce que la fréquence d'échantillonnage est divisée par deux dans des intervalles de temps consécutifs ($R_1$, ..., $R_6$).

7. Procédé selon l'une des revendications 2 à 6, caractérisé en ce que la durée des intervalles de temps consécutifs ($R_1$, ..., $R_6$) est doublée.

8. Procédé selon l'une des revendications 2 à 7, caractérisé en ce que les intervalles de temps ($R_2$, ..., $R_6$) à fréquence d'échantillonnage différente contiennent le même nombre de points de trame et respectivement de périodes d'exploration.

9. Procédé selon l'une des revendications 1 à 8, caractérisé en ce que l'intervalle de temps ($R_1$) avec la fréquence d'échantillonnage maximale démarrant au début du processus d'exploration contient un nombre de périodes plus grand que l'intervalle de temps suivant ($R_2$).

10. Procédé selon la revendication 9, caractérisé en ce que l'intervalle de temps ($R_1$) avec la fréquence d'échantillonnage maximale démarrant au début du processus d'exploration contient un nombre de périodes d'exploration deux fois plus grand que l'intervalle de temps suivant ($R_2$).

11. Procédé selon l'une des revendications 1 à 10, caractérisé en ce que la séquence de valeurs mesurées de chaque signal est mémorisée dans un support d'enregistrement numérique (21; 21', 21") et, pour la détermination de la fréquence de battement, analysée de préférence par une transformation de Fourier rapide (FFT).

12. Procédé selon l'une des revendications 1 à 11, caractérisé en ce que le début du signal et la fin du signal sont déterminés métrologiquement.

13. Procédé selon l'une des revendications 1 à 12, caractérisé en ce que, au cours de l'exploration, la séquence de valeurs mesurées est enregistrée dans au moins une mémoire intermédiaire conformée en mémoire FIFO (21', 21'') ou RAM (21).

14. Procédé selon l'une des revendications 1 à 13, caractérisé en ce qu'une séquence de valeurs mesurées correspondant à une trame partielle équidistante est utilisée pour l'analyse, l'écartement de trame correspondant à l'écartement de trame d'un intervalle de temps ($R_5$) à proximité de la fin du signal.

15. Procédé selon l'une des revendications 1 à 14, caractérisé en ce que l'intensité momentanée du signal ($S_E$) est comparée en continu avec une première valeur seuil et avec une seconde valeur seuil supérieure à la première, que le début du signal est déterminé et l'exploration démarrée lors du dépassement de la seconde valeur seuil, que l'on mesure respectivement l'intervalle de temps entre un dépassement vers le haut de la seconde valeur seuil et un dépassement vers le bas de la première valeur seuil, qu'à la suite de la descente en dessous de la première valeur seuil, on détermine un temps de contrôle qui est plus long que l'intervalle de temps mesuré auparavant, et que la détermination de la fin du signal et l'interruption de l'exploration interviennent au plus tard si la seconde valeur seuil n'est pas dépassée à l'intérieur du temps de contrôle.

16. Procédé selon la revendication 15, caractérisé en ce que le temps de contrôle est choisi au moins deux fois, de préférence quatre fois plus long que l'intervalle de temps mesuré auparavant.

17. Procédé selon l'une des revendications 1 à 16, caractérisé en ce que l'intensité momentanée du signal ($S_E$) est comparée avec une troisième valeur seuil située au-dessus de la seconde valeur seuil, que lors de l'atteinte d'un maximum relatif du signal au-dessus de la troisième valeur seuil, éventuellement après une descente en dessous d'une première valeur seuil située en dessous de la seconde valeur seuil, la durée momentanée du signal mesurée à compter du début du signal est déterminée, avec démarrage d'un temps d'évanouissement succédant à la durée de signal déterminée, et que l'exploration est interrompue dès que le temps d'évanouissement démarré en dernier est terminé.

18. Procédé selon la revendication 17, caractérisé en ce que le temps d'évanouissement est de 0,6 à 1,8 fois, de préférence de 0,8 à 1,2 fois, la durée momentanée du signal déterminée auparavant.

19. Procédé selon l'une des revendications 17 ou 18, caractérisé en ce que l'exploration est interrompue dès que le temps d'évanouissement démarré en dernier est terminé et que l'intensité du signal ($S_E$) est passée en même temps au-dessous d'une quatrième valeur seuil prédéterminée.

20. Procédé selon la revendication 19, caractérisé en ce que la quatrième valeur seuil correspond à la première valeur seuil.

21. Procédé selon l'une des revendications 1 à 20, caractérisé en ce que la séquence de valeurs mesurées stockée dans une mémoire intermédiaire (21; 21', 21'') est compressée progressivement au cours de l'exploration, avec génération d'une séquence de valeurs de mesure associée à une trame de temps équidistante.

22. Procédé selon la revendication 21, caractérisé en ce que la trame de temps équidistante correspond à la fréquence d'échantillonnage momentanée.

23. Procédé selon l'une des revendications 21 ou 22, caractérisé en ce que les valeurs intermédiaires non-équidistantes stockées a une fréquence d'échantillonnage plus élevée sont écrasées, pour la compression, par des valeurs de mesure associées à la trame de temps équidistante.

24. Dispositif pour déterminer la fréquence de battement de signaux impulsionnels modulés en amplitude ou en intensité, en particulier de signaux de lumière diffusée déclenchés par des particules en mouvement et modulés par des effets de clair-obscur alternant dans l'espace, comprenant un récepteur de signaux (15, 16), un convertisseur analogique/numérique (17) qui reçoit le signal de sortie ($S_E$) du récepteur de signaux et à la sortie duquel peut être prélevée une séquence de valeurs de mesure numériques, des moyens d'enregistrement numérique (21; 21', 21'') recevant la séquence de valeurs de mesure numériques, une logique de reconnaissance des signaux (18), un cadenceur (19, 20) pouvant être commandé par le signal de sortie ($S_p$) de la logique de reconnaissance des signaux (18) et destiné à générer un signal de synchronisation qui synchronise le convertisseur analogique/numérique (17) et/ou les moyens d'enregistrement (21; 21', 21'') avec la fréquence d'échantillonnage, et un système d'interprétation (23) pour la détermination de la fréquence de battement à partir de la séquence de valeurs de mesure numériques, caractérisé en ce que le convertisseur analogique/numérique (17) peut être commandé avec un signal de synchronisation dont la fréquence d'échantillonnage diminue dans le temps.

25. Dispositif selon la revendication 24, caractérisé en ce que la fréquence d'échantillonnage peut être réduite progressivement dans des intervalles de temps consécutifs ($R_1$, ..., $R_6$).

26. Dispositif selon la revendication 25, caractérisé en ce que le cadenceur (19, 20) comprend un diviseur de fréquence d'échantillonnage (20) dans lequel la fréquence d'échantillonnage peut être divisée par deux dans des intervalles de temps consécutifs.

27. Dispositif selon l'une des revendications 25 ou 26, caractérisé en ce qu'il comprend des éléments de circuit pour doubler la longueur des intervalles de temps consécutifs.

28. Dispositif selon l'une des revendications 24 à 27, caractérise en ce que la séquence de valeur de mesure mémorisée dans les moyens d'enregistrement numérique, est utilisée pour la détermination de la fréquence de battement, avec application d'une transformation de Fourier rapide.

29. Dispositif selon l'une des revendications 24 à 28, caractérisé en ce que les moyens d'enregistrement numérique (21; 21', 21'') sont réalisés sous la forme de mémoires FIFO ou RAM.

30. Dispositif selon l'une des revendications 24 à 29, caractérisé en ce qu'il comprend un circuit ou un programme pour la sélection et l'analyse d'une séquence de valeurs de mesure correspondant à une trame de temps partielle ($R_F$) équidistante, l'écartement de trame correspondant à la fréquence d'échantillonnage à proximité de la fin du signal.

31. Dispositif selon l'une des revendications 24 à 30, caractérisé en ce qu'il comprend un montage pour la compression de la séquence de valeur de mesure stockée dans les moyens d'enregistrement (21; 21''), en fonction de la trame de temps partielle correspondant à la fréquence d'échantillonnage momentanée (fig. 4).

Fig. 1

Fig. 2

Fig. 3

Fig. 4

**Fig. 7**

**Fig. 5**

Fig. 6

Fig. 8

EP 0 464 675 B1